# FASCICULE DE BREVET EUROPEEN

(11) **EP 3 138 109 B1**
(45) Date de publication et mention de la délivrance du brevet: **13.01.2021**
(21) Numéro de dépôt: 15724336.1
(22) Date de dépôt: 16.04.2015
(51) Int. Cl.: H01F 10/32, G01R 33/028, H01F 41/30

(54) **AIMANT PERMANENT COMPORTANT UN EMPILEMENT DE COUCHES FERROMAGNETIQUES ET ANTIFERROMAGNETIQUES**
DAUERMAGNET ENTHALTEND EIN STAPEL FERROMAGNETISCHER UND ANTIFERROMAGNETISCHER SCHICHTEN
PERMANENT MAGNET COMPRISING A STACKING OF FERROMAGNETIC AND ANTIFERROMAGNETIC LAYERS

(30) Priorité: 28.04.2014 FR 1453839
(43) Date de publication de la demande: 08.03.2017
(73) Titulaire: Commissariat à l'Energie Atomique et aux Energies Alternatives, 75015 Paris (FR)
(72) Inventeur: DELAET, Bertrand, 38190 Bernin (FR); CARTIER, Mathilde, 38000 Grenoble (FR); CYRILLE, Marie- Claire, 38650 Sinard (FR)
(74) Mandataire: Colombo, Michel
(86) Numéro de dépôt international: PCT/FR2015/051040
(87) Numéro de publication internationale: WO 2015/166159

(56) Documents cités:
- EP-A1- 2 597 655
- JP-A- 2006 010 579
- US-A1- 2004 075 957
- ETTELT DIRK ET AL: "3D Magnetic Field Sensor Concept for Use in Inertial Measurement Units (IMUs)", JOURNAL OF MICROELECTROMECHANICAL SYSTEMS, IEEE SERVICE CENTER, US, vol. 23, no. 2, 1 avril 2014 (2014-04-01), pages 324-333, XP011544447, ISSN: 1057-7157, DOI: 10.1109/JMEMS.2013.2273362 [extrait le 2014-03-31]
- NOZIÈRES J P ET AL: "Blocking temperature distribution and long-term stability of spin-valve structures with Mn-based antiferromagnets", JOURNAL OF APPLIED PHYSICS, AMERICAN INSTITUTE OF PHYSICS, US, vol. 87, no. 8, 15 avril 2000 (2000-04-15) , pages 3920-3925, XP012049836, ISSN: 0021-8979, DOI: 10.1063/1.372435

## Description

L'invention concerne un aimant permanent ainsi qu'un capteur de champ magnétique incorporant cet aimant permanent. L'invention concerne également un procédé de fabrication de cet aimant permanent.

Des capteurs connus de champ magnétique incorporent des aimants permanents pour mesurer l'amplitude, dans une direction donnée, d'un champ magnétique à mesurer. De tels capteurs sont décrits, par exemple, en référence à la figure 4 de la demande US 2011/0151589 ou en référence aux figures 1A à 8 de la demande WO 2010/0084165.

Les aimants permanents utilisés dans ces capteurs, contrairement aux couches piégées (« pinned layer » en anglais) utilisées dans les vannes de spin ou GMR (« Giant Magnetoresistance ») et dans les jonctions tunnels ou TMR (« Tunnel Magnetoresistance »), doivent générer un champ magnétique important. Pour rappel, dans les vannes de spin et les jonctions tunnels, le champ magnétique généré par la couche piégée doit au contraire être faible pour permettre à la direction d'aimantation de la couche libre de tourner et de s'aligner sur la direction d'un champ magnétique extérieur. Ainsi dans les aimants permanents, l'aimantation des couches piégées est figée alors que dans le cas de structures dynamiques, comme des structures MRAM (Magnetoresistive Random Access Memory) ou TAMRAM (Thermally-Assisted Magnetic Random Access Memories) par exemple, cette aimantation évolue lors de l'utilisation de la structure.

Pour obtenir un champ magnétique important, dans les capteurs connus, l'aimant permanent est réalisé par un empilement de couches ferromagnétiques et de couches antiferromagnétiques. Typiquement, cet empilement comporte :
- au moins une couche antiferromagnétique, et
- au moins deux premières couches ferromagnétiques, la direction d'aimantation de chaque première couche ferromagnétique étant piégée, par un couplage d'échange, avec l'une des couches antiferromagnétiques de l'empilement, parallèlement et dans le même sens que les directions d'aimantation des autres premières couches ferromagnétiques.

Plus précisément, dans les aimants permanents connus chaque couche ferromagnétique est coincée entre deux couches antiferromagnétiques. Par la suite, par couches ferromagnétiques et antiferromagnétiques, on désigne des couches réalisées, respectivement, en matériau ferromagnétique et en matériau antiferromagnétique. De tels modes de réalisation d'un aimant permanent sont décrits en référence à la figure 1A de la demande US 2011/0151589 et en référence aux figures 10A et 10B de la demande WO 2010/0084165.

Par la suite, le champ magnétique d'un tel aimant permanent comportant un empilement de couches ferromagnétiques et antiferromagnétiques est considéré comme important si la relation suivante est vérifiée : ΣMᵢtᵢsᵢ ≥ 50 x 10⁻⁹ T.m et, de préférence, supérieur à 10⁻⁷ T.m, où :
- Mᵢ est l'amplitude de l'aimantation de la couche ferromagnétique Cᵢ d'épaisseur tᵢ,
- Sᵢ est égal à « +1 » si la direction du moment magnétique de la couche ferromagnétique Cᵢ est parallèle et de même sens que le moment magnétique global de l'aimant permanent et, égal à « -1 » si la direction du moment magnétique de la couche ferromagnétique Cᵢ est parallèle et de sens opposé à la direction du moment magnétique global de l'aimant permanent,
- i est le numéro d'ordre de la couche Cᵢ dans l'empilement de couches ferromagnétiques et antiferromagnétiques de l'aimant permanent, et
- le symbole « Σ » est la somme pour toutes les couches ferromagnétiques existantes dans l'empilement de couches ferromagnétiques et antiferromagnétiques.

Pour information, cette somme ΣMᵢtᵢsᵢ est en général très inférieure à 50 x 10⁻⁹ T.m dans les couches de référence ou couches piégées des vannes de spin ou jonctions tunnels pour les raisons indiquées ci-dessus.

Écrire qu'un aimant permanent vérifie la relation suivante ΣMᵢtᵢsᵢ ≥ 50 x 10⁻⁹ T.m est équivalent à dire que le moment magnétique total de cet aimant par unité de surface est supérieur à (50 x 10⁻²)/(4π) A. En effet, un moment magnétique µ s'exprime en A.m² dans le Système International (SI) ou en emu dans le système CGS. L'aimantation M est égale au moment magnétique µ par unité de volume et s'exprime donc en A/m dans le Système International ou en emu/cm3 dans le système CGS. Donc une aimantation M multipliée par une épaisseur t s'exprime en A dans le Système International ou en emu/cm² dans le système CGS. C'est parce qu'une aimantation M multipliée par une épaisseur t s'exprime en A dans le système SI ou en emu/cm² dans le système CGS qu'on qualifie ce produit de moment magnétique par unité de surface. Dès lors, le champ magnétique d'un aimant permanent est important si son moment magnétique par unité de surface est supérieur à (50 x 10⁻² )/(4π) A et, de préférence, supérieur à 1/(4π) A.

Le moment magnétique par unité de surface d'un aimant permanent comportant un empilement de couches ferromagnétiques et antiferromagnétique peut facilement être mesuré. Par exemple, le moment magnétique de l'aimant permanent est mesuré par la méthode VSM (« Vibrating Sample Magnetometry »). Cette méthode est bien connue. Elle est par exemple décrite dans les articles suivants :
- Simon FONER, « Versatile and Sensitive Vibrating-Sample Magnetometer », The review of scientific instrucments, Volume 30, number 7, juillet 1959,
- Christian Albrechts, « Vibrating Sample Magnetometry », Université de Kiel, M106, 2011.

Le moment magnétique ainsi mesuré est alors divisé par le volume de matériau ferromagnétique contenu dans cet aimant pour obtenir son aimantation. Quel que soit l'empilement, les dimensions des couches ferromagnétiques peuvent être facilement mesurées, par exemple, par observation de coupes verticales de cet empilement avec un microscope. En particulier, ces observations permettent de mesurer l'épaisseur tᵢ de chaque couche ferromagnétique. Enfin, l'aimantation ainsi obtenue est multipliée par la somme des épaisseurs tᵢ de chaque couche ferromagnétique pour obtenir le moment magnétique de cet aimant par unité de surface. Généralement, les couches ferromagnétiques de l'empilement ont toutes la même surface dans un plan perpendiculaire à la direction d'empilement de ces couches. Par conséquent, on peut aussi diviser le moment magnétique mesuré pour l'aimant par la surface des couches ferromagnétiques, ou par la surface de l'aimant permanent si elle est égale à la surface des couches ferromagnétiques, pour obtenir le moment magnétique par unité de surface.

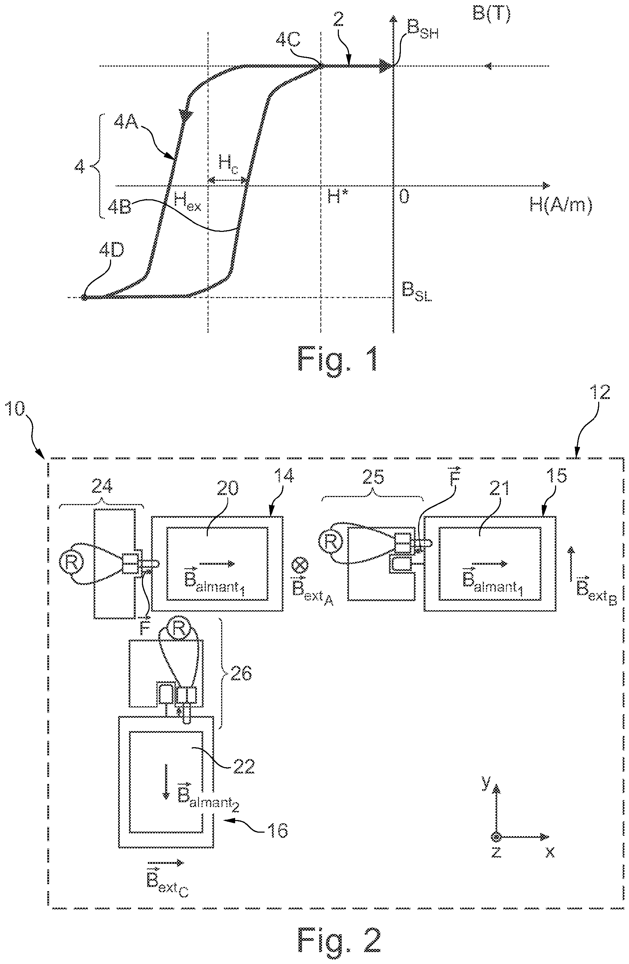

L'aimantation d'un tel aimant permanent, présente typiquement un cycle d'hystérésis tel que celui représenté sur la figure 1.

La figure 1 va maintenant être utilisée pour définir certains termes. La courbe 2 représente l'évolution de l'aimantation, notée B sur les figures, de l'aimant permanent en fonction du champ magnétique H. Plus précisément, l'aimantation B varie entre deux valeurs extrêmes B_{SL} et B_{SH}. Lorsque l'aimantation de l'aimant permanent atteint la valeur B_{SH}, son aimantation ne peut plus augmenter même si le champ magnétique H augmente. On dit alors que l'aimant est saturé. Le même phénomène se produit lorsque l'aimantation atteint la valeur B_{SL} et que le champ magnétique continue à diminuer. Entre ces deux valeurs extrêmes, la courbe 2 définit un cycle 4 d'hystérésis. Le cycle 4 comporte :
- une courbe 4A qui descend au fur et à mesure que le champ magnétique H diminue, et
- une courbe 4B qui monte au fur et à mesure que le champ magnétique H augmente.

Les courbes 4A et 4B se rejoignent d'un côté en un point 4C et de l'autre côté en un point 4D. Entre ces points 4C et 4D, les courbes 4A et 4B sont distinctes. Au-delà du point 4C et en-deçà du point 4D, les courbes 4A et 4B sont confondues et l'aimant permanent est saturé. Ici, le point 4C est le plus proche de l'axe des ordonnées.

Au niveau des points 4C et 4D, l'écart entre les courbes 4A et 4B est égal à 1 % de la valeur B_{SH}.

Dans le cas des aimants permanents formés par l'empilement de couches ferromagnétiques et antiferromagnétiques, le cycle 4 d'hystérésis est, généralement, décalé vers la gauche comme représenté sur la figure 1. Plus précisément, le cycle 4 est décalé, par rapport à l'axe des ordonnées, d'une valeur Hₑₓ appelée par la suite champ d'échange Hₑₓ ou champ Hₑₓ. Ce champ Hₑₓ est également connu sous le terme anglais de « exchange bias ». Typiquement, la valeur du champ Hₑₓ correspond à la valeur de l'abscisse du point situé à mi-distance entre les deux points où le cycle 4 coupe cet axe des abscisses. Dans ce graphe, l'axe des abscisses représente le champ magnétique H.

Le champ coercitif H_{c} ou champ H_{c} de l'aimant permanent est la demi-largeur du cycle 4. Typiquement, sa valeur est prise égale à la différence entre la valeur du champ Hₑₓ et un point d'intersection du cycle 4 avec l'axe des abscisses.

On définit également le champ H* comme étant le plus petit champ magnétique à partir duquel l'hystérésis de l'aimant permanent disparaît, c'est-à-dire comme précisé ci-dessus, le champ magnétique pour laquelle l'hystérésis est inférieure à 1% de la valeur B_{SH}. Ici, la valeur du champ H* est égale à la valeur de l'abscisse du point 4C.

Plus l'aimant permanent contient une quantité importante de matériaux ferromagnétiques, plus la sensibilité du capteur de champ magnétique augmente. Ainsi, une solution connue pour augmenter la sensibilité du capteur de champ magnétique consiste à augmenter le nombre de couches ferromagnétiques et antiferromagnétiques empilées dans l'aimant permanent. Toutefois, cela conduit en même temps à augmenter l'encombrement de l'aimant permanent ainsi qu'à augmenter la quantité de matériaux antiferromagnétiques. Cela induit par ailleurs des difficultés de réalisation liées notamment à la structuration d'un empilement épais.

De l'état de la technique est également connu de :
- US2004/075957A1,
- ETTELT DIRK et Al : « 3D Magnetic Field Sensor Concept for use in Inertial Measurment Units (IMUs) », Journal of Microelectromechanical systems, IEEE Service center, US, vol. 23, n°2, 1 avril 2014, pages 324-333,
- NOZIERES JP et Al : « Blocking temperature distribution and long-term stability of spin-valve structures with Mn-Based antiferromagnets », Journal of applied physics, American Institute of Physics, US, Vol. 87, n°8, 15/04/2000, pages 3920-3925,
- JP2006010579A,
- EP2597655A .

L'invention vise à augmenter la quantité de matériaux ferromagnétiques d'un aimant obtenu par l'empilement de couches ferromagnétiques et antiferromagnétiques sans nécessairement augmenter la quantité de matériaux antiferromagnétiques contenus dans cet aimant permanent.

A cet effet, l'invention a pour objet un aimant permanent conforme à la revendication 1.

L'aimant permanent ci-dessus comporte en plus, par rapport aux aimants connus, des secondes couches ferromagnétiques dont les directions d'aimantation sont uniquement piégées par un couplage RKKY (Ruderman-Kittel-Kasuya-Yoshida). L'utilisation d'un couplage RKKY dans cet aimant permanent permet de piéger la direction d'aimantation des secondes couches ferromagnétiques sans avoir à ajouter de matériaux antiferromagnétiques dans l'empilement et sans avoir à modifier l'épaisseur des couches antiferromagnétiques qui piègent la direction d'aimantation des premières couches ferromagnétiques. Ainsi, lorsqu'un tel aimant permanent est utilisé dans un capteur de champ magnétique, cela permet d'augmenter la sensibilité du capteur sans augmenter la quantité de matériaux antiferromagnétiques utilisés pour réaliser l'aimant permanent. Cela permet également d'obtenir un aimant permanent dont le champ H* est plus élevé que dans l'art antérieur.

Les modes de réalisation de cet aimant permanent peuvent comporter une ou plusieurs des caractéristiques des revendications dépendantes.

Ces modes de réalisation de l'aimant permanent présentent en outre les avantages suivants :
- choisir l'épaisseur des premières couches ferromagnétiques de manière à ce que le champ H* résultant pour l'aimant soit de même signe que Hₑₓ et de valeur absolue supérieure à 795 A/m voire avantageusement à 3978 A/m, permet d'augmenter l'insensibilité de l'aimant permanent aux perturbations magnétiques extérieures ;
- utiliser uniquement des couplages RKKY ferromagnétiques pour piéger la direction d'aimantation des secondes couches ferromagnétiques permet, pour une même quantité de matériaux ferromagnétiques contenus dans l'empilement d'obtenir une aimantation globale pour l'aimant permanent supérieure à celle des autres configurations possibles ;
- utiliser des couplages RKKY antiferromagnétiques pour piéger la direction d'aimantation des secondes couches ferromagnétiques, permet d'obtenir un aimant permanent plus stable car le couplage est plus fort;
- utiliser un motif comprenant une superposition de p secondes couches ferromagnétiques simplifie le procédé de fabrication de cet aimant permanent ;
- utiliser un motif comportant une couche antiferromagnétique utilisée pour piéger, par couplage d'échange, de chaque côté, une couche ferromagnétique permet de limiter encore plus la quantité de matériaux antiferromagnétiques utilisée pour réaliser cet empilement ;
- réaliser l'aimant permanent avec un facteur de forme supérieur ou égale à deux permet de faciliter l'alignement de la direction d'aimantation de chaque couche ferromagnétique dans la direction longitudinale de l'aimant permanent lors de sa fabrication.

L'invention a également pour objet un capteur de champ magnétique conforme à la revendication indépendante de capteur.

Enfin, l'invention a également pour objet un procédé de fabrication de l'aimant permanent ci-dessus.

L'invention sera mieux comprise à la lecture de la description qui va suivre, donnée uniquement à titre d'exemple non limitatif tout en se référant aux dessins sur lesquels :
- la figure 1 est une illustration schématique du cycle d'hystérésis d'un aimant permanent réalisé à partir d'un empilement de couches ferromagnétiques et antiferromagnétiques ;
- la figure 2 est une illustration schématique en vue de dessus d'un capteur de champ magnétique ;
- la figure 3 est une illustration schématique en coupe verticale longitudinale d'un aimant permanent du capteur de la figure 2 ;
- la figure 4 est un graphe illustrant le cycle d'hystérésis de l'aimant permanent dans deux cas particuliers du facteur de forme ;
- la figure 5 est un organigramme d'un procédé de fabrication de l'aimant permanent de la figure 3 ;
- les figures 6 à 8 sont des illustrations schématiques en coupe verticale longitudinale d'autres modes de réalisation possibles des aimants permanents du capteur de la figure 2.

Dans ces figures, les mêmes références sont utilisées pour désigner les mêmes éléments. Dans la suite de cette description, les caractéristiques et fonctions bien connues de l'homme du métier ne sont pas décrites en détail.

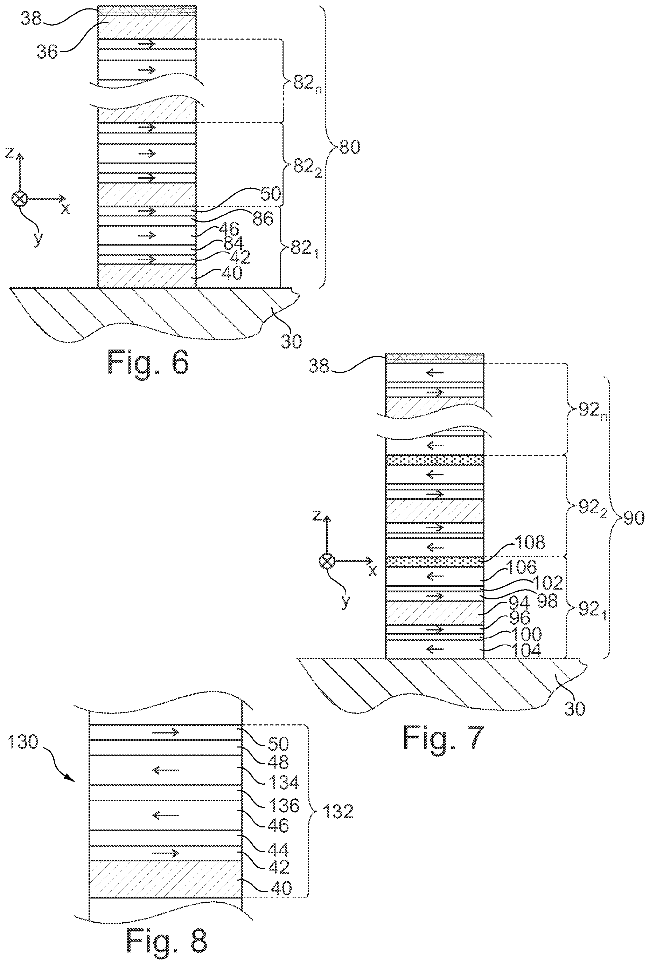

La figure 2 représente un capteur 10 de champ magnétique. Ce capteur 10 est identique au capteur décrit en référence à la figure 8 de la demande WO 2010/0084165, sauf en ce qui concerne la structure des aimants permanents utilisés. Ainsi, seule une brève description de l'architecture générale de ce capteur est donnée pour illustrer un exemple de réalisation d'un tel capteur.

Ce capteur 10 comprend :
- un substrat 12 s'étendant essentiellement dans un plan horizontal parallèle à des directions orthogonales X et Y, et
- trois magnétomètres 14 à 16 mono-axes réalisés sur le substrat 12.

Une direction Z, perpendiculaire aux directions X et Y, représente la verticale. Par la suite, les figures suivantes sont orientées par rapport à ce même repère X, Y, Z. De plus, les termes tels que « au-dessus », « en dessous », « en bas », « en haut » sont définis par rapport à cette direction Z.

Les magnétomètres 14 à 16 mesurent l'amplitude du champ magnétique à mesurer dans les directions, respectivement, Z, Y et X. A cet effet, chaque magnétomètre 14 à 16 comporte :
- un aimant permanent, respectivement 20 à 22, apte à se déplacer par rapport au substrat 12, et
- un transducteur, respectivement 24 à 26, apte à transformer le déplacement de l'aimant permanent en une variation de courant ou de tension correspondante.

Par exemple, les transducteurs 24 à 26 sont des transducteurs piézorésistifs. Typiquement, ces transducteurs sont fixés, sans degré de liberté, d'un côté sur le substrat 12 et, d'un autre côté, à l'aimant permanent.

Ici, les aimants permanents 20 à 22 sont identiques à l'exception du fait que la direction du moment magnétique globale de l'aimant permanent 22 est perpendiculaire à celle des aimants permanents 20 et 21. Dès lors, seule une description détaillée de l'aimant permanent 20 est donnée par la suite.

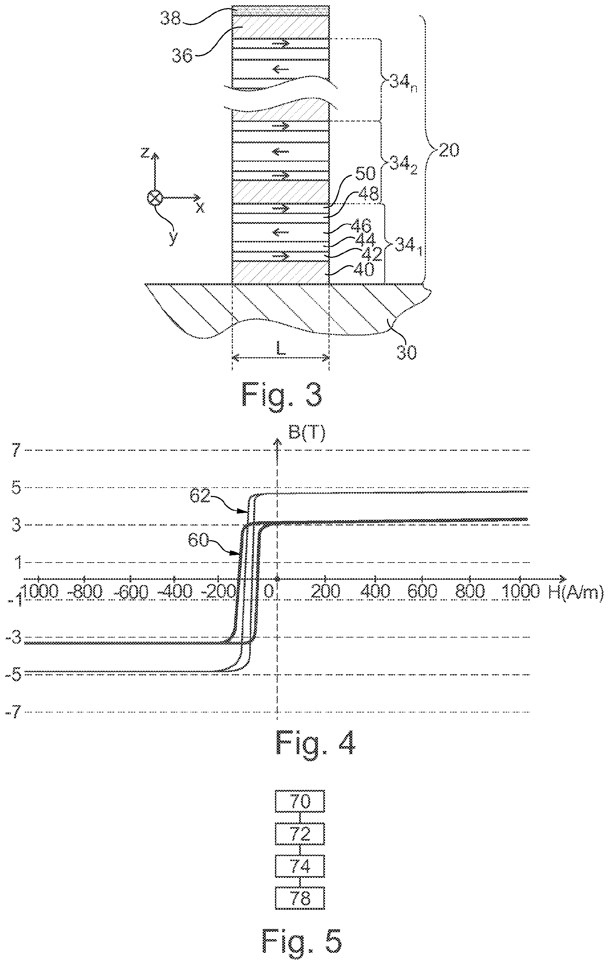

La figure 3 représente l'aimant permanent 20 déposé sur un socle 30 mobile par rapport au substrat 12. Par exemple, le socle 30 est obtenu par gravure du substrat 12. Seule une portion de ce socle 30 est représentée sur la figure 3.

L'aimant 20 est formé d'un empilement, dans une direction d'empilement, de couches ferromagnétiques et antiferromagnétiques. Ici, la direction d'empilement est parallèle à la direction Z. Sur la figure 3 et les suivantes, les conventions suivantes sont adoptées :
- les couches antiferromagnétiques sont hachurées,
- la direction du moment magnétique d'une couche ferromagnétique est représentée par une flèche,
- les lignes ondulées au milieu de l'empilement indiquent qu'une portion intermédiaire de cet empilement n'a pas été représentée,
- les proportions entre les épaisseurs des différentes couches ne sont pas respectées pour améliorer la lisibilité des figures, et
- la proportion entre la longueur L et la hauteur de l'empilement n'est pas respectée pour réduire la taille des figures dans la direction longitudinale de l'empilement.

Ici, l'empilement présente une forme parallélépipédique et un facteur de forme supérieur ou égal à 2, 5 ou 20, voire même supérieur à 100 ou 1000. Dans ce mode de réalisation, le facteur de forme est défini comme étant le rapport de la longueur L sur la largeur W de l'empilement. Ici, la longueur est parallèle à la direction X et la largeur W est parallèle à la direction Y.

Plus le facteur de forme est important et plus il est facile d'aligner la direction d'aimantation des couches ferromagnétiques sur la direction longitudinale de l'empilement. Par exemple, la largeur de l'empilement est inférieure à 20 µm ou 10 µm et la longueur L est supérieure à 50 µm ou 100 µm ou 1 mm. La hauteur de l'empilement est généralement supérieure à 100 µm ou 500 µm. Cette hauteur est mesurée entre la couche de l'empilement la plus proche du socle 30 et la couche de ce même empilement la plus éloignée du socle 30.

Ici, l'empilement de couches ferromagnétiques et antiferromagnétiques est composé successivement dans la direction Z :
- d'un motif 34 répété n fois, puis
- d'une couche antiferromagnétique 36 puis, typiquement,
- d'une couche 38 d'encapsulation déposée au sommet de cet empilement.

La couche 38 est destinée à protéger l'aimant permanent des agressions chimiques et/ou physiques de l'environnement extérieur. Cette couche 38 est réalisée dans un matériau non magnétique. Par matériau non magnétique, on désigne ici un matériau dépourvu de propriété magnétique susceptible de perturber le fonctionnement de l'aimant permanent 20. Généralement, il s'agit d'un matériau dont les propriétés magnétiques sont nulles ou non mesurables.

Par exemple, la couche 38 est réalisée en tantale (Ta) et son épaisseur est supérieure ou égale à 5 nm.

La couche 36 est par exemple identique à la couche 40 décrite plus loin.

Par la suite, la première occurrence du motif 34 dans l'empilement, c'est-à-dire celle qui est la plus proche du socle 30 porte la référence 34₁, la seconde occurrence immédiatement au-dessus de cette première occurrence 34₁ porte la référence 342 et ainsi de suite jusqu'à l'occurrence 34ₙ.

Ici, les occurrences 34₁ à 34ₙ sont directement empilées les unes au-dessus des autres et ne sont donc séparées les unes des autres par aucune autre couche n'appartenant pas au motif 34.

Le nombre n de répétitions du motif 34 est généralement choisi pour atteindre une hauteur souhaitée de l'empilement. Cette hauteur dépend de l'application envisagée. Toutefois, de préférence, n est supérieur ou égal à 2, 5 ou 10. n est également généralement inférieur à 50 ou 100.

Dans ce mode de réalisation, les différentes occurrences du motif 34 sont toutes identiques les unes aux autres et seule l'occurrence 34₁ va donc être décrite en détail.

L'occurrence 34₁ est composée successivement dans la direction Z :
- d'une couche antiferromagnétique 40,
- d'une couche ferromagnétique 42 dont la direction d'aimantation est piégée par couplage d'échange avec la couche antiferromagnétique 40,
- une couche 44 non-magnétique connue sous le terme de « espaceur » ou « spacer » en anglais,
- une couche ferromagnétique 46 dont la direction d'aimantation est piégée par couplage RKKY (Ruderman-Kittel-Kasuya-Yosida) antiferromagnétique avec la couche ferromagnétique 42,
- une couche 48 non-magnétique formant un espaceur, et
- une couche ferromagnétique 50 dont la direction d'aimantation est piégée par couplage d'échange avec la couche antiferromagnétique 40 de l'occurrence 342 du motif 34 situé juste au-dessus de l'occurrence 34₁.

Dans cette description, les matériaux antiferromagnétiques utilisés sont par exemple choisis dans le groupe composé :
- des alliages de manganèse, et
- du NiO, et
- du Fe₂O₃.

Les alliages de manganèse antiferromagnétiques sont typiquement le PtMn, NiMn, PdPtMn, FeMn et IrMn. Dans cet exemple, le matériau antiferromagnétique choisi pour la couche 40 est l'alliage PtMn.

De même, dans cette description, les matériaux ferromagnétiques utilisés pour réaliser les couches ferromagnétiques sont choisis dans le groupe composé du cobalt, du nickel, du fer et de leurs alliages. Par exemple, le matériau ferromagnétique est souvent du CoFe ou NiFe ou CoFeB. Ici, la couche 42 est réalisée en CoFe.

Dans ce mode de réalisation, la direction d'aimantation c'est-à-dire la direction du moment magnétique, de la couche 42 est parallèle et de même sens que la direction X. Typiquement, l'amplitude de l'aimantation à saturation de la couche 42 est supérieure ou égale à 0,5 T ou 1 T ou 2 T. On rappelle ici qu'un Tesla est égal à 10⁷/(4π) A/m,

Cette direction d'aimantation est piégée par un couplage d'échange avec la couche 40. Un couplage d'échange entre une couche ferromagnétique et une couche antiferromagnétique apparaît si :
- la couche ferromagnétique est directement déposée sur la couche antiferromagnétique, ou
- uniquement séparée de la couche antiferromagnétique par une (ou plusieurs) très fine(s) couche(s) non-magnétique(s) dont l'épaisseur totale est inférieure à 0,5 nm et, de préférence, inférieure à 0,4 nm ou 0,2 nm.

Le couplage d'échange entre les couches ferromagnétique et antiferromagnétique est bien connu. Par exemple, le lecteur peut se référer à l'article suivant : J. Nogués et Ivan K. Schuller, « *Exchange bias* » Journal of magnetism and magnetic materials 192 (1999), 203-232.

La présence du couplage d'échange entre la couche ferromagnétique et la couche antiferromagnétique se traduit notamment par un décalage, par exemple, vers la gauche comme illustré sur la figure 1, du cycle d'hystérésis de l'assemblage de ces deux couches et donc par l'apparition d'un champ Hₑₓ non nul.

Ici, l'épaisseur des couches 40 et 42 sont choisies pour obtenir un bon couplage d'échange entre ces deux couches. Dans cette description, on considère que le couplage d'échange est bon si :
- cela se traduit par un ratio Hₑₓ/H_{c} strictement supérieur à 1 et, de préférence, supérieur à 2 ou 4, et
- l'apparition d'un champ d'échange Hₑₓ dont la valeur absolue est supérieure à 50 Oe (3978 A/m) et, de préférence, supérieure à 100 Oe (7957 A/m) ou 200 Oe (15915 A/m) ou 500 Oe (39788 A/m) à 25°C.

Les champs Hₑₓ et H_{c} d'un empilement comportant seulement les couches 40 et 42 peut être mesuré expérimentalement ou obtenu par simulation numérique.

Un bon couplage d'échange permet en cas de perturbation magnétique extérieure importante de revenir à l'état initial après la disparition de cette perturbation.

L'épaisseur des couches 40 et 42 est, par exemple, déterminée par expérimentation ou par simulation numérique en testant successivement des épaisseurs différentes pour un empilement formé seulement d'une couche antiferromagnétique et d'une couche ferromagnétique réalisées dans les mêmes matériaux que les couches 40 et 42. Pour les matériaux antiferromagnétiques et ferromagnétiques les plus courants, les épaisseurs appropriées sont connues de l'homme du métier. Par exemple, typiquement, l'épaisseur de la couche 40 est comprise entre 5 et 100 nm et, de préférence, entre 7 et 25 nm ou entre 10 et 25 nm. L'épaisseur de la couche 42 est souvent comprise entre 0,5 nm et 100 nm. Dans cet exemple, l'épaisseur de la couche 40 est deux ou trois ou dix fois supérieure à l'épaisseur de la couche 42 pour obtenir ce bon couplage d'échange. Ici, l'épaisseur de la couche 40 est de 20 nm tandis que l'épaisseur de la couche 42 est de 0,8 nm.

La couche 44 est réalisée dans un matériau non-magnétique. Dans cette description, les matériaux non magnétiques utilisés sont typiquement choisis dans le groupe composé du ruthénium, du rhodium, de l'argent, du chrome, du tantale du cuivre, etc.... Ici, la couche 44 est en ruthénium. L'épaisseur de la couche 44 est choisie pour qu'il existe un couplage RKKY entre la couche 42 et la couche ferromagnétique 46. Selon l'épaisseur de la couche 44, le couplage RKKY est soit ferromagnétique, c'est-à-dire que les directions d'aimantation des couches ferromagnétiques couplées sont identiques, soit antiferromagnétique, c'est-à-dire que les directions d'aimantation des couches ferromagnétiques couplées sont opposées. Si l'on trace l'évolution du couplage RKKY entre les couches ferromagnétiques en fonction de l'épaisseur de la couche 44, on obtient une sinusoïde amortie. Le premier extremum, dans l'ordre des épaisseurs croissantes de la couche non-magnétique, de cette sinusoïde amortie correspond à un couplage RKKY antiferromagnétique et le second extremum correspond à un couplage RKKY ferromagnétique. Dans les modes de réalisation décrits ici, ce sont ces couplages RKKY correspondant aux deux premiers extremums de la sinusoïde amortie qui sont utilisés. Par exemple, dans le cas d'une couche non-magnétique en ruthénium, le couplage RKKY antiferromagnétique est obtenu pour une épaisseur de 0,8 nm tandis que le couplage RKKY ferromagnétique est obtenu pour une épaisseur de 1,4 nm.

Ici, l'épaisseur de la couche 44 est de 0,8 nm et, par conséquent, les couches 42 et 46 sont couplées magnétiquement par un couplage RKKY antiferromagnétique.

La direction d'aimantation de la couche 46 est donc piégée, dans ce mode de réalisation, sans qu'il soit nécessaire pour cela d'utiliser un couplage d'échange et donc une couche antiferromagnétique supplémentaire.

L'épaisseur de la couche 46 peut être choisie pour être importante car l'épaisseur de cette couche n'a pas d'influence sur la qualité du couplage d'échange entre les couches 40 et 42. Ici, l'épaisseur de la couche 46 est choisie pour que la relation suivante soit vérifiée : M₂t₂ ≥ X*M₁t₁, où :
- M₁ et t₁ sont, respectivement, l'aimantation et l'épaisseur de la couche ferromagnétique 42, et
- M2 et t2 sont, respectivement, l'aimantation et l'épaisseur de la couche ferromagnétique 46,
- X est un nombre entier égal à deux et, de préférence, égal à cinq ou dix ou 15.

Dans l'exemple, la couche 46 est réalisée dans le même matériau ferromagnétique que la couche 42.

Ainsi, pour augmenter sensiblement la quantité de matériaux ferromagnétiques de l'aimant permanent 20, l'épaisseur de la couche 46 est choisie de préférence supérieure à deux ou cinq ou dix fois l'épaisseur de la couche 42. Par exemple, l'épaisseur de la couche 46 est supérieure à 5 ou 10 nm et généralement inférieure à 100 nm. Pour les simulations suivantes, l'épaisseur de la couche 46 est prise égale à 16 nm.

L'amplitude de l'aimantation à saturation de la couche 46 est aussi supérieure à 0,5 T ou 1 T ou 2 T.

La couche 48 est un espaceur non magnétique dont l'épaisseur est choisie pour créer un couplage RKKY antiferromagnétique entre les couches ferromagnétiques 46 et 50. A cet effet, elle est identique à la couche 44.

La couche ferromagnétique 50 est couplée magnétiquement d'un côté à la couche 46 par le couplage RKKY antiferromagnétique et, de l'autre côté, à la couche antiferromagnétique 40 de l'occurrence 342. La couche 50 est conçue pour qu'il existe un bon couplage d'échange avec la couche antiferromagnétique 40 de l'occurrence 342. Pour cela, l'épaisseur de la couche 50 peut être choisie comme l'épaisseur de la couche 42. Par exemple, ici, les couches 50 et 42 sont structurellement identiques.

On notera que dans ce mode de réalisation, les directions d'aimantation des couches 42 et 50 sont piégées par des couplages d'échange alors que la direction d'aimantation de la couche 46 est uniquement piégée par des couplages RKKY.

La superposition des couches 42 à 50 forme ce qui est connu sous l'acronyme de SAF (« Synthetic antiferromagnetic »). Ici, on définit un SAF comme étant une superposition de couches ferromagnétiques et non-magnétiques dans laquelle toutes les couches ferromagnétiques sont couplées magnétiquement les unes aux autres par des couplages RKKY antiferromagnétiques. Le moment magnétique d'un tel SAF est proportionnel à la somme suivante : Σ Mᵢtᵢsᵢ, où :
- les termes Mᵢ, tᵢ et sᵢ sont les mêmes que ceux définis dans l'introduction de cette demande, et
- le symbole « Σ » est la somme pour toutes les couches ferromagnétiques existantes dans ce SAF.

Ici, les épaisseurs des couches ferromagnétiques sont choisies de manière à ce que cette somme ne soit pas nulle. On dit alors qu'il s'agit d'un SAF déséquilibré (« unbalanced SAF » en anglais). Dans ce mode de réalisation, le SAF comporte trois couches ferromagnétiques et il est donc aussi appelé double-SAF.

Le moment magnétique global de l'aimant permanent 20 est proportionnel à la somme des moments magnétiques des SAF de l'empilement.

Dans ce mode de réalisation, l'épaisseur des couches 42 et 50 est réduite pour obtenir un bon couplage d'échange et donc pour accroître la valeur du champ Hₑₓ. De plus, grâce à l'introduction de la couche ferromagnétique 46 dont la direction d'aimantation est uniquement piégée par des couplages RKKY, il est aussi possible d'accroître le ratio R. Le ratio R est égal au rapport du volume de matériaux ferromagnétiques sur le volume de matériaux antiferromagnétiques contenus dans l'aimant 20. Dès lors, ce mode de réalisation permet à la fois d'accroître le ratio Hₑₓ/H_{c} tout en maintenant ou en augmentant le ratio R. Ainsi, l'aimant permanent 20 présente :
- une insensibilité accrue aux perturbations magnétiques extérieures car l'augmentation du ratio Hₑₓ/H_{c} éloigne le champ H* de l'axe des ordonnées, et
- la sensibilité du capteur incorporant cet aimant permanent est meilleure car le volume de matériaux ferromagnétiques a été accru.

Enfin, augmenter le ratio Hₑₓ/H_{c} est également utile pour fabriquer l'aimant 20 avec la forme d'un barreau longiligne. En effet, il est connu que la mise en forme de l'aimant permanent sous la forme d'un barreau longiligne ayant un facteur de forme important augmente la valeur du champ H_{c} alors que le champ Hₑₓ reste constant. Ainsi, si avant une mise en forme le ratio Hₑₓ/H_{c} n'est pas assez important, après mise en forme, le champ H* est très proche de zéro ou supérieur à zéro de sorte que ce barreau aimanté est alors très sensible aux perturbations magnétiques extérieures. Ce phénomène est représenté sur la figure 4.

Le graphe de la figure 4 représente :
- un cycle d'hystérésis 60 de l'aimant permanent 20 dans le cas particulier où sa longueur est égale à 200 µm et sa largeur W est égale à 4 µm, et
- un cycle d'hystérésis 62 d'un empilement identique à celui de l'aimant permanent 20 mais réalisé sur une surface importante, par exemple supérieure à 1 ou 5 mm² et avec un facteur de forme égal à un.

Les cycles 60 et 62 ont été obtenus par mesure. Ils illustrent clairement le fait que le ratio Hₑₓ/H_{c} diminue quand l'aimant permanent est mis en forme pour avoir un facteur de forme important.

La figure 5 représente un procédé de fabrication de l'aimant permanent 20. Plus précisément, lors d'une étape 70, les différentes couches décrites en référence à la figure 3 sont déposées les unes sur les autres. Pour cela, on utilise des méthodes connues dans le domaine des microtechnologies et de la réalisation des puces électroniques. Lors de l'étape 70, aucune mise en forme particulière n'est donnée à cet empilement de couches. Cet empilement recouvre au moins les emplacements où doivent être réalisés les aimants 20 à 22.

Lors d'une étape 72, cet empilement est structuré pour ne laisser subsister que des empilements en forme de barreau aux emplacements où les aimants 20 à 22 doivent être réalisés. Ainsi, à l'issue de cette étape, il ne subsiste que des barreaux ayant les facteurs de forme requis, c'est-à-dire généralement supérieur à 2, 10 ou 100.

Ensuite, lors d'une étape 74, les barreaux sont chauffés pour que la température des couches antiferromagnétiques dépasse leur température de mise en ordre. Ce recuit est effectué sous champ magnétique saturant comme décrit par exemple dans la demande US 2011/0151589.

Ensuite comme décrit par exemple dans la demande US 2011/0151589, lors d'une étape 78, les barreaux sont refroidis sous un champ plus faible jusqu'à ce que les couplages d'échange entre les couches ferromagnétiques et antiferromagnétiques apparaissent et piègent les directions d'aimantation de chaque couche ferromagnétique. On obtient alors les aimants permanents 20 à 22.

Pour les autres étapes de fabrication du capteur 10, le lecteur peut se référer aux demandes de brevet précédemment citées dans l'introduction.

La figure 6 représente un aimant permanent 80. L'aimant 80 est identique à l'aimant 20 sauf que le motif 34 est remplacé par un motif 82. Le motif 82 est identique au motif 34 sauf que les couches non-magnétiques 44 et 48 sont remplacées, respectivement, par des couches non-magnétiques 84 et 86. La couche 84 est identique à la couche 42 sauf que son épaisseur est choisie pour obtenir un couplage RKKY ferromagnétique entre les couches ferromagnétiques 42 et 46. Par exemple, l'épaisseur de la couche 84 est choisie égale à 1,4 nm. La couche 86 est identique à la couche 84.

Dans ce mode de réalisation, les directions d'aimantation de toutes les couches ferromagnétiques sont dans le même sens. Ainsi, pour un même nombre n de motifs que dans le mode de réalisation de la figure 3, l'amplitude du moment magnétique de l'aimant permanent 80 est supérieure à l'amplitude du moment magnétique de l'aimant permanent 20. Toutefois, l'énergie de couplage RKKY entre les couches 46 et les couches 42 et 50 est plus faible que dans le cas de l'aimant permanent 20. Dans ce mode de réalisation, l'empilement des couches ferromagnétiques 42, 84, 46, 86, 50 forment un empilement que l'on désignera par la suite par FSF. Un FSF comme un SAF est une superposition de couches ferromagnétiques et non-magnétiques dans laquelle toutes les couches ferromagnétiques sont couplées magnétiquement les unes aux autres par des couplages RKKY. Toutefois, dans un FSF, au moins l'un de ces couplages RKKY est un couplage RKKY ferromagnétique.

La figure 7 représente un aimant permanent 90. L'aimant 90 est identique à l'aimant 20 sauf que le motif 92 répété n fois est différent du motif 34. Le motif 92 comporte :
- une couche antiferromagnétique 94,
- deux couches ferromagnétiques 96, 98 situées de part et d'autre de la couche antiferromagnétique 94 et dont les directions d'aimantation sont piégées par couplage d'échange avec la couche 94,
- deux couches non-magnétiques 100, 102 en contact direct, respectivement, avec les couches ferromagnétiques 96 et 98,
- deux couches ferromagnétiques 104 et 106 dont les directions d'aimantation sont uniquement piégées par des couplages RKKY antiferromagnétique avec, respectivement, les couches ferromagnétiques 96 et 98, et
- une couche 108 de lamination qui isole magnétiquement la couche ferromagnétique 106 de la couche 104 de l'occurrence 92₂ du motif 92 situé juste au-dessus.

Les couplages d'échange et les couplages RKKY antiferromagnétiques dans le motif 92 sont, par exemple, obtenus comme décrit en référence au motif 34. Ainsi, ici, les couches 94, 96, 98, 100 et 102 sont identiques aux couches, respectivement, 40, 42, 50, 44 et 48. Les couches 104 et 106 sont, par exemple, identiques à la couche 46.

La couche de lamination 108 découple magnétiquement la couche 106 des couches de l'occurrence 922. Par exemple, cette couche de lamination est réalisée dans un matériau non magnétique choisi dans le groupe composé des matériaux suivants MgO, Mg, Ta, TiO₂. Typiquement, son épaisseur est supérieure à 5 ou 10 nm.

Ainsi, le motif 92 comporte :
- deux couches ferromagnétiques 96 et 98 dont les directions d'aimantation sont piégées par couplage d'échange avec la couche antiferromagnétique 94, et
- deux couches ferromagnétiques 104, 106 dont les directions d'aimantation sont uniquement piégées par des couplages RKKY.

Dans ce mode de réalisation, le piégeage des directions d'aimantation des couches 96 et 98 par couplage d'échange est obtenu en utilisant seulement une seule couche antiferromagnétique et non pas deux comme dans l'aimant 20.

La figure 8 représente un aimant permanent 130. Cet aimant 130 est identique à l'aimant 20 sauf que le motif 34 est remplacé par un motif 132. Pour simplifier la figure 8, seul le motif 132 est représenté. Le motif 132 est identique au motif 34 sauf qu'une couche ferromagnétique 134 et une couche non-magnétique 136 sont insérées entre les couches 48 et 46 du motif 34. La couche 134 est réalisée, par exemple, dans le même matériau ferromagnétique que les couches 42, 46 et 50. Par exemple, la couche 134 est identique à la couche 46. La direction d'aimantation de la couche 134 est piégée par un couplage RKKY antiferromagnétique avec la couche 50. A cet effet, la couche 48 est interposée entre les couches ferromagnétiques 50 et 134. La direction d'aimantation de la couche 134 est également piégée par un couplage RKKY ferromagnétique avec la couche 46. A cet effet, la couche 136 est interposée entre les couches ferromagnétiques 134 et 46. L'épaisseur de la couche 136 est choisie pour obtenir un couplage RKKY ferromagnétique. Par exemple, la couche 136 est une couche de ruthénium de 1,4 nm d'épaisseur.

Le motif 132 forme un FSF à quatre couches ferromagnétiques dans lequel les directions d'aimantation de deux de ces couches ferromagnétiques sont uniquement piégées par des couplages RKKY.

De nombreux autres modes de réalisation sont possibles. Par exemple, l'épaisseur des couches 100 et 102 peut être augmentée de manière à obtenir un couplage RKKY ferromagnétique entre les couches 96 et 104 et entre les couches 98 et 106 au lieu d'un couplage RKKY antiferromagnétique.

L'épaisseur des couches non magnétiques 44, 48 et 136 peut également être modifiée pour obtenir uniquement des couplages RKKY ferromagnétiques entre les différentes couches ferromagnétiques du même motif.

Le motif 82 comporte un FSF à trois couches ferromagnétiques. Le motif 132 comporte un FSF à quatre couches ferromagnétiques. En variante, ces FSF peuvent être remplacés par un FSF ou un SAF à p couches ferromagnétiques, où p est un nombre entier supérieur ou égal à 5 ou 6. Généralement, p reste inférieur à 10.

Dans une autre variante, p est égal à deux. Pour cela, par exemple, les couches 96, 100 et 104 du motif 92 sont omises. Toutefois, dans cette dernière variante, le nombre n de motifs est alors supérieur ou égal à deux pour avoir dans l'empilement au moins deux couches ferromagnétiques dont les directions d'aimantation sont piégées par couplage d'échange avec une couche antiferromagnétique.

De même, dans le motif 92, l'un ou les deux SAF situés de part et d'autre de la couche antiferromagnétique 94 peuvent être chacun remplacés par des SAF ou FSF à plus de deux couches ferromagnétiques.

Les différentes couches ferromagnétiques du même motif ne sont pas nécessairement réalisées dans les mêmes matériaux ferromagnétiques. Par exemple, une de ces couches peut être réalisée en CoFe et une autre en NiFe.

Les épaisseurs des différentes couches ferromagnétiques piégées par un couplage d'échange peuvent être différentes les unes des autres. Par exemple, l'épaisseur des couches 42 et 50 ou des couches 96 et 98 sont différentes l'une de l'autre. De même, les épaisseurs des couches ferromagnétiques dont les directions d'aimantation sont uniquement piégées par des couplages RKKY peuvent être différentes. Par exemple, les épaisseurs des couches 104 et 106 ou les épaisseurs des couches 46 et 134 sont différentes l'une de l'autre.

Dans les modes de réalisation précédents, les couches ferromagnétiques dont les directions d'aimantation sont piégées par couplage d'échange ont une épaisseur cinq ou dix fois inférieure à l'épaisseur des couches ferromagnétiques dont les directions d'aimantation sont uniquement piégées par des couplages RKKY. Ainsi, dans ces modes de réalisation, pour chaque paire de couches ferromagnétiques comportant une couche ferromagnétique dont la direction d'aimantation est piégée par couplage d'échange et une couche ferromagnétique dont la direction d'aimantation est piégée par couplage RKKY, la première relation suivante est vérifiée M₂t₂ ≥ X*M₁t₁, où X est égal à cinq ou dix. En variante, ce rapport entre les épaisseurs n'est pas respecté. Par exemple, l'épaisseur des couches ferromagnétiques dont les directions d'aimantation sont piégées par couplage d'échange est cinq à dix fois supérieure à celle des couches ferromagnétiques dont les directions d'aimantation sont uniquement piégées par couplage RKKY. Ainsi, en variante, un empilement est construit en utilisant un motif identique au motif 34 sauf que l'épaisseur des couches 42 et 50 est supérieure ou égale à 10 nm et l'épaisseur de la couche 46 est inférieure à 1 nm. Dans cette variante, c'est une deuxième relation, inverse de la première relation, c'est-à-dire Mᵢt₁ ≥ X*M₂t₂ qui est vérifiée pour chaque paire de couches ferromagnétiques, avec X égal à cinq ou dix. A partir du moment où l'empilement respecte la première ou la deuxième relation, la quantité de matériau ferromagnétique à l'intérieur de cet empilement est substantiellement augmentée sans pour autant accroître la quantité de matériau anti-ferromagnétique.

Il est également possible de combiner, dans un même empilement, des motifs différents. Par exemple, il est possible de construire un empilement en alternant les motifs 34 et 82 ou les motifs 34 et 132.

L'empilement n'a pas nécessairement une forme parallélépipédique. Par exemple, la section de l'empilement parallèlement aux directions X, Y est une ellipse ou un ovale. Dans ces derniers cas, le facteur de forme de l'aimant permanent est défini comme étant le rapport de la longueur sur la largeur du parallélépipède de plus petit volume contenant entièrement l'empilement.

En variante, le facteur de forme de l'empilement n'est pas nécessairement supérieur ou égal à deux. Par exemple, il peut être égal à un.

Une couche d'accroché entre la première occurrence du motif et le socle 30 sur lequel doit être fixé l'aimant permanent peut être prévue pour améliorer l'adhésion du premier motif sur ce socle.

Les couches ferromagnétiques ne sont pas nécessairement formées chacune par un seul bloc homogène de matériau ferromagnétique. Par exemple, chaque couche ferromagnétique peut aussi être laminée comme décrit dans la demande de brevet FR 2 892 871 dans le passage page 13, lignes 5 à 9.

Les couches ferromagnétiques peuvent également être constituées d'un ensemble de plusieurs lames ferromagnétiques directement superposées les unes sur les autres comme par exemple des bicouches de NiFe/CoFe ou TbCo/CoFeB.

## Revendications

1. Aimant permanent comprenant un empilement de couches ferromagnétiques et antiferromagnétiques dont le moment magnétique par unité de surface est supérieur à (50 x 10⁻²)/(4π) A,
cet empilement comportant à cet effet :
- au moins deux premières couches ferromagnétiques (42, 50 ; 96, 98), la direction d'aimantation de chaque première couche ferromagnétique étant figée, par un couplage d'échange, avec l'une des couches antiferromagnétiques de l'empilement, parallèlement et dans le même sens que les directions d'aimantation des autres premières couches ferromagnétiques, et l'empilement comporte également au moins une seconde couche ferromagnétique (46; 104, 106; 46, 134), la direction d'aimantation de chaque seconde couche ferromagnétique étant piégée uniquement par couplage RKKY (Ruderman-Kittel-Kasuya-Yosida) avec au moins l'une des premières couches ferromagnétiques ou avec au moins une autre des secondes couches ferromagnétiques,
caractérisé à ce qu'il y a au moins deux couches antiferromagnétiques.

2. Aimant selon la revendication 1, dans lequel l'épaisseur de chaque première couche ferromagnétique (42, 50 ; 96, 98) est choisie de manière à ce que l'assemblage de cette première couche ferromagnétique avec la couche antiferromagnétique à laquelle elle est liée par un couplage d'échange forme un aimant dont le champ H* est de même signe que le champ Hₑₓ de cet aimant et dont la valeur absolue du champ H* est supérieure à 795 A/m, le champ H* étant la plus petite intensité de champ magnétique à partir de laquelle l'hystérésis de cet aimant disparaît, et le champ Hₑₓ étant le champ d'échange.

3. Aimant selon la revendication 2, dans lequel l'épaisseur de chaque première couche ferromagnétique (42, 50 ; 96, 98) est au moins cinq fois inférieure à l'épaisseur de la couche antiferromagnétique avec laquelle elle est liée par un couplage d'échange.

4. Aimant selon l'une quelconque des revendications précédentes, dans lequel chaque couplage RKKY entre une seconde couche ferromagnétique (46) et la première (42, 50) ou une autre des secondes couches ferromagnétiques est systématiquement un couplage RKKY ferromagnétique.

5. Aimant selon l'une quelconque des revendications 1 à 3, dans lequel chaque couplage RKKY entre une seconde couche ferromagnétique (46 ; 104, 106) et la première (42, 48 ; 96, 98) ou une autre seconde couche ferromagnétique est systématiquement un couplage RKKY antiferromagnétique.

6. Aimant selon l'une quelconque des revendications précédentes, dans lequel l'empilement comporte :
- une couche antiferromagnétique d'extrémité (36), cette couche antiferromagnétique d'extrémité étant la plus proche d'un sommet de l'empilement, et
- immédiatement sous cette couche antiferromagnétique d'extrémité, un motif (34 ; 82; 132) répété n fois, immédiatement successivement, dans une direction d'empilement des couches ferromagnétiques et antiferromagnétiques, où n est un entier supérieur ou égal à un, ce motif comportant dans l'ordre en se déplaçant dans la direction d'empilement :
- une première couche antiferromagnétique (40),
- une première couche ferromagnétique (42) dont la direction d'aimantation est piégée par couplage d'échange avec la première couche antiferromagnétique,
- une superposition de p secondes couches ferromagnétiques (46 ; 46, 134), la direction d'aimantation de la seconde couche ferromagnétique (46), située en bas de cette superposition, étant piégée par couplage RKKY avec la première couche ferromagnétique (42) située au-dessous, et la direction d'aimantation de chaque autre seconde couche ferromagnétique (134) de cette superposition étant piégée par couplage RKKY avec la seconde couche ferromagnétique (46) de cette superposition située juste en dessous, où p est un nombre entier supérieur ou égal à un, et
- une première couche ferromagnétique (50) dont la direction d'aimantation est piégée par couplage d'échange avec la première couche antiferromagnétique (40) du motif suivant dans l'empilement ou avec la couche antiferromagnétique d'extrémité (36).

7. Aimant selon la revendication 6, dans lequel p est compris entre un et dix, et de préférence entre un et deux.

8. Aimant selon l'une quelconque des revendications 1 à 5, dans lequel l'empilement comporte un motif (92) répété n fois, immédiatement successivement, dans une direction d'empilement des couches antiferromagnétiques et ferromagnétiques, où n est un entier supérieur ou égal à un, ce motif comportant :
- une couche antiferromagnétique (94),
- de chaque côté de cette couche antiferromagnétique :
• une première couche ferromagnétique (96, 98) dont la direction d'aimantation est piégée par couplage d'échange avec cette couche antiferromagnétique, et
• une seconde couche ferromagnétique (104, 106) dont la direction d'aimantation est piégée par couplage RKKY avec cette première couche ferromagnétique, et
- une couche de lamination (108) en matériau non-magnétique située à l'une des extrémité de ce motif pour isoler magnétiquement ce motif du motif immédiatement suivant ou précédent dans ce même empilement.

9. Aimant selon l'une quelconque des revendications 6 ou 8, dans lequel n est supérieur ou égal à deux ou cinq.

10. Aimant selon l'une quelconque des revendications précédentes, dans lequel l'aimant présente un facteur de forme supérieur ou égal à deux, le facteur de forme étant défini comme le rapport de la longueur sur la largeur du parallélépipède de plus petit volume contenant entièrement l'empilement et la direction d'aimantation de chaque couche ferromagnétique de l'aimant permanent étant piégée dans une direction parallèle à la longueur de ce parallélépipède.

11. Aimant selon l'une quelconque des revendications précédentes, dans lequel, pour toutes les paires de couches ferromagnétiques de l'empilement, l'une des relations choisies dans le groupe composé des relations M₁t₁ ≥ 5*M₂t₂ et M₂t₂ ≥ 5*M₁t₁, est satisfaite, où :
- M₁ et t₁ sont, respectivement, l'aimantation et l'épaisseur de la première couche ferromagnétique de la paire, et
- M2 et t2 sont, respectivement, l'aimantation et l'épaisseur de la seconde couche ferromagnétique de la même paire,
chaque paire de couches ferromagnétiques de l'empilement comportant une seconde couche ferromagnétique et la première couche ferromagnétique qui piège, uniquement par couplage RKKY, la direction d'aimantation de cette seconde couche ferromagnétique.

12. Capteur de champ magnétique comportant :
- un substrat (12) s'étendant essentiellement dans un plan appelé « plan du substrat »,
- au moins un aimant permanent (20-22 ; 80 ; 90 ; 130) déplaçable par rapport au substrat en réponse à une variation de l'amplitude ou de la direction d'un champ magnétique à mesurer,
- un transducteur (24-26) fixé sur le substrat, apte à convertir un déplacement de l'aimant permanent en une grandeur électrique représentative de l'amplitude ou de la direction du champ magnétique à mesurer,
**caractérisé en ce que** l'aimant permanent est conforme à l'une quelconque des revendications 1 à 11.

13. Procédé de fabrication d'un aimant permanent conforme à l'une quelconque des revendications 1 à 11, ce procédé comportant :
a) la formation (70) d'un empilement de premières couches ferromagnétiques et antiferromagnétiques,
b) le chauffage (74) de l'empilement de manière à atteindre une température supérieure à une température de mise en ordre du matériau des couches magnétiques de l'empilement,
c) lorsque la température est supérieure à la température de mise en ordre, l'application (76) d'un premier champ magnétique pour aligner la direction d'aimantation des couches ferromagnétiques sur une direction souhaitée prédéterminée,
d) le refroidissement (78) de l'empilement en présence d'un deuxième champ magnétique inférieur au premier champ magnétique pour faire apparaître un couplage d'échange entre chaque première couche ferromagnétique et une couche antiferromagnétique du même empilement, et
l'étape a) comporte la formation, dans l'empilement, de secondes couches ferromagnétiques séparées des premières couches ferromagnétiques et des autres secondes couches ferromagnétiques par des couches non magnétiques dont l'épaisseur est apte à permettre l'apparition d'un couplage RKKY entre cette seconde couche ferromagnétique et cette première couche ferromagnétique ou cette autre seconde couche ferromagnétique de manière à piéger la direction magnétique de cette seconde couche ferromagnétique uniquement par un couplage RKKY avec l'une des premières couches ferromagnétiques ou avec au moins l'une des autres secondes couches ferromagnétiques.

## Patentansprüche

1. Dauermagnet, der einen Stapel ferromagnetischer und antiferromagnetischer Schichten beinhaltet, deren magnetisches Moment pro Flächeneinheit größer als (50 x 10⁻²)/(4π) A ist,
wobei dieser Stapel zu diesem Zweck Folgendes umfasst:
mindestens zwei erste ferromagnetische Schichten (42, 50; 96, 98), wobei die Magnetisierungsrichtung jeder ersten ferromagnetischen Schicht durch eine Austauschkopplung mit einer der antiferromagnetischen Schichten des Stapels festgehalten wird, parallel und richtungsgleich zu den Magnetisierungsrichtungen der anderen ersten ferromagnetischen Schichten,
und wobei der Stapel ebenfalls mindestens eine zweite ferromagnetische Schicht (46; 104, 106; 46, 134) umfasst, wobei die Magnetisierungsrichtung jeder zweiten ferromagnetischen Schicht nur durch eine Ruderman-Kittel-Kasuya-Yosida(RKKY)-Kopplung mit mindestens einer der ersten ferromagnetischen Schichten oder mit mindestens einer anderen der zweiten ferromagnetischen Schichten gepinnt wird,
**dadurch gekennzeichnet, dass** es mindestens zwei antiferromagnetische Schichten gibt.

2. Magnet nach Anspruch 1, wobei die Dicke jeder ersten ferromagnetischen Schicht (42, 50; 96, 98) so ausgewählt ist, dass der Verbund dieser ersten ferromagnetischen Schicht mit der antiferromagnetischen Schicht, mit der sie durch eine Austauschkopplung verbunden ist, einen Magneten bildet, dessen Feld H* dasselbe Vorzeichen wie das Feld Hₑₓ dieses Magneten aufweist und dessen Absolutwert des Felds H* größer als 795 A/m ist, wobei das Feld H* die kleinste Magnetfeldstärke ist, ab der die Hysterese dieses Magneten verschwindet, und wobei das Feld Hₑₓ das Austauschfeld ist.

3. Magnet nach Anspruch 2, wobei die Dicke jeder ersten ferromagnetischen Schicht (42, 50; 96, 98) mindestens fünfmal kleiner als die Dicke der antiferromagnetischen Schicht ist, mit der sie durch eine Austauschkopplung verbunden ist.

4. Magnet nach einem der vorhergehenden Ansprüche, wobei jede RKKY-Kopplung zwischen einer zweiten ferromagnetischen Schicht (46) und der ersten (42, 50) oder einer anderen der zweiten ferromagnetischen Schichten systematisch eine ferromagnetische RKKY-Kopplung ist.

5. Magnet nach einem der Ansprüche 1 bis 3, wobei jede RKKY-Kopplung zwischen einer zweiten ferromagnetischen Schicht (46; 104, 106) und der ersten (42, 48; 96, 98) oder einer anderen zweiten ferromagnetischen Schicht systematisch eine antiferromagnetische RKKY-Kopplung ist.

6. Magnet nach einem der vorhergehenden Ansprüche, wobei der Stapel Folgendes umfasst:
- eine antiferromagnetische Endschicht (36), wobei diese antiferromagnetische Endschicht einer Stapeloberseite am nächsten ist, und
- unmittelbar unter dieser antiferromagnetischen Endschicht ein Muster (34; 82; 132), das sich in einer Stapelrichtung der ferromagnetischen und antiferromagnetischen Schichten unmittelbar aufeinanderfolgend n Mal wiederholt, wobei n eine ganze Zahl größer als oder gleich eins ist, wobei dieses Muster entlang der Stapelrichtung der Reihenfolge nach Folgendes umfasst:
- eine erste antiferromagnetische Schicht (40),
- eine erste ferromagnetische Schicht (42), deren Magnetisierungsrichtung durch eine Austauschkopplung mit der ersten antiferromagnetischen Schicht gepinnt wird,
- eine Übereinanderschichtung von p zweiten ferromagnetischen Schichten (46; 46, 134), wobei die Magnetisierungsrichtung der zweiten ferromagnetischen Schicht (46), die sich in dieser Übereinanderschichtung unten befindet, durch eine RKKY-Kopplung mit der ersten ferromagnetischen Schicht (42), die sich darunter befindet, gepinnt wird und wobei die Magnetisierungsrichtung jeder anderen zweiten ferromagnetischen Schicht (134) dieser Übereinanderschichtung durch eine RKKY-Kopplung mit der direkt darunterliegenden zweiten ferromagnetischen Schicht (46) dieser Übereinanderschichtung gepinnt wird, wobei p eine ganze Zahl größer als oder gleich eins ist, und
- eine erste ferromagnetische Schicht (50), deren Magnetisierungsrichtung durch eine Austauschkopplung mit der ersten antiferromagnetischen Schicht (40) des folgenden Musters in dem Stapel oder mit der antiferromagnetischen Endschicht (36) gepinnt wird.

7. Magnet nach Anspruch 6, wobei p zwischen eins und zehn und vorzugsweise zwischen eins und zwei liegt.

8. Magnet nach einem der Ansprüche 1 bis 5, wobei der Stapel ein Muster (92) umfasst, das sich in einer Stapelrichtung der antiferromagnetischen und ferromagnetischen Schichten unmittelbar aufeinanderfolgend n Mal wiederholt, wobei n eine ganze Zahl größer als oder gleich eins ist, wobei dieses Muster Folgendes umfasst:
- eine antiferromagnetische Schicht (94),
- auf jeder Seite dieser antiferromagnetischen Schicht:
• eine erste ferromagnetische Schicht (96, 98), deren Magnetisierungsrichtung durch eine Austauschkopplung mit dieser antiferromagnetischen Schicht gepinnt wird, und
• eine zweite ferromagnetische Schicht (104, 106), deren Magnetisierungsrichtung durch eine RKKY-Kopplung mit dieser ersten ferromagnetischen Schicht gepinnt wird, und
- eine Laminierungsschicht (108) aus nichtmagnetischem Material, die sich an einem der Enden dieses Musters befindet, um dieses Muster von dem unmittelbar folgenden oder vorhergehenden Muster in diesem Stapel magnetisch zu isolieren.

9. Magnet nach einem der Ansprüche 6 oder 8, wobei n größer als oder gleich zwei oder fünf ist.

10. Magnet nach einem der vorhergehenden Ansprüche, wobei der Magnet einen Formfaktor größer als oder gleich zwei aufweist, wobei der Formfaktor als das Verhältnis von Länge zu Breite des Parallelepipeds mit kleinerem Volumen, das den Stapel komplett enthält, definiert ist und die Magnetisierungsrichtung jeder ferromagnetischen Schicht des Dauermagneten in einer zu der Länge dieses Parallelepipeds parallelen Richtung gepinnt wird.

11. Magnet nach einem der vorhergehenden Ansprüche, wobei für alle Paare von ferromagnetischen Schichten des Stapels eine der Beziehungen, die aus der Gruppe ausgewählt sind, die aus den Beziehungen Mᵢt₁ ≥ 5*M₂t₂ und M2t2 ≥ 5*M₁t₁ besteht, erfüllt ist, wobei:
- M₁ und t₁ jeweils die Magnetisierung und die Dicke der ersten ferromagnetischen Schicht des Paares sind und
- M2 und t2 jeweils die Magnetisierung und die Dicke der zweiten ferromagnetischen Schicht desselben Paares sind,
wobei jedes Paar von ferromagnetischen Schichten des Stapels eine zweite ferromagnetische Schicht und die erste ferromagnetische Schicht, die die Magnetisierungsrichtung dieser zweiten ferromagnetischen Schicht nur durch eine RKKY-Kopplung pinnt, umfasst.

12. Magnetfeldsensor, der Folgendes umfasst:
- ein Substrat (12), das sich im Wesentlichen in einer Ebene, die als "Substratebene" bezeichnet wird, erstreckt,
- mindestens einen Dauermagneten (20-22; 80; 90; 130), der als Reaktion auf eine Veränderung der Amplitude oder der Richtung eines zu messenden Magnetfelds mit Bezug auf das Substrat bewegbar ist,
- einen Wandler (24-26), der auf dem Substrat befestigt ist und fähig ist, eine Bewegung des Dauermagneten in eine elektrische Größe umzuwandeln, die für die Amplitude oder die Richtung des zu messenden Magnetfelds repräsentativ ist, **dadurch gekennzeichnet, dass** der Dauermagnet einem der Ansprüche 1 bis 11 entspricht.

13. Verfahren zur Fertigung eines Dauermagneten, der einem der Ansprüche 1 bis 11 entspricht, wobei dieses Verfahren Folgendes umfasst:
a) Bilden (70) eines Stapels aus ersten ferromagnetischen und antiferromagnetischen Schichten,
b) Erwärmen (74) des Stapels, um eine Temperatur zu erreichen, die größer als eine Ordnungstemperatur des Materials der magnetischen Schichten des Stapels ist,
c) wenn die Temperatur größer als eine Ordnungstemperatur ist, Anwenden (76) eines ersten Magnetfelds, um die Magnetisierungsrichtung der ferromagnetischen Schichten auf eine vorgegebene gewünschte Richtung auszurichten,
d) Abkühlen (78) des Stapels in Gegenwart eines zweiten Magnetfelds, das kleiner als das erste Magnetfeld ist, um eine Austauschkopplung zwischen jeder ersten ferromagnetischen Schicht und einer antiferromagnetischen Schicht desselben Stapels hervorzurufen,
und wobei der Schritt a) das Bilden, in dem Stapel, von zweiten ferromagnetischen Schichten umfasst, die von den ersten ferromagnetischen Schichten und den anderen zweiten ferromagnetischen Schichten durch nichtmagnetische Schichten getrennt sind, deren Dicke fähig ist, das Auftreten einer RKKY-Kopplung zwischen dieser zweiten ferromagnetischen Schicht und dieser ersten ferromagnetischen Schicht oder dieser anderen zweiten ferromagnetischen Schicht derart zu gestatten, dass die magnetische Richtung dieser zweiten ferromagnetischen Schicht nur durch eine RKKY-Kopplung mit einer der ersten ferromagnetischen Schichten oder mit mindestens einer der anderen zweiten ferromagnetischen Schichten gepinnt wird.

## Claims

1. Permanent magnet including a stack of ferromagnetic and antiferromagnetic layers the magnetic moment of which per unit surface area is greater than (50 x 10⁻²)/ (4π) A,
this stack comprising for this purpose:
- at least two first ferromagnetic layers (42, 50; 96, 98), the magnetization direction of each first ferromagnetic layer being set, by an exchange coupling, with one of the antiferromagnetic layers of the stack, parallel to and in the same direction as the magnetization directions of the other first ferromagnetic layers,
and the stack also comprises at least one second ferromagnetic layer (46; 104, 106; 46, 134), the magnetization direction of each second ferromagnetic layer being pinned only by RKKY (Ruderman-Kittel-Kasuya-Yosida) coupling with at least one of the first ferromagnetic layers or with at least one other of the second ferromagnetic layers,
**characterized in that** there are at least two antiferromagnetic layers.

2. Magnet according to Claim 1, in which the thickness of each first ferromagnetic layer (42, 50; 96, 98) is selected so that the assembly of this first ferromagnetic layer with the antiferromagnetic layer to which it is linked by an exchange coupling forms a magnet of which the field H* is of the same sign as the field Hₑₓ of this magnet and of which the absolute value of the field H* is greater than 795 A/m, the field H* being the smallest intensity of magnetic field from which the hysteresis of this magnet disappears, and the field Hₑₓ being the exchange field.

3. Magnet according to Claim 2, in which the thickness of each first ferromagnetic layer (42, 50; 96, 98) is at least five times less than the thickness of the antiferromagnetic layer with which it is linked by an exchange coupling.

4. Magnet according to any one of the preceding claims, in which each RKKY coupling between a second ferromagnetic layer (46) and the first (42, 50) or another of the second ferromagnetic layers is systematically a ferromagnetic RKKY coupling.

5. Magnet according to any one of Claims 1 to 3, in which each RKKY coupling between a second ferromagnetic layer (46; 104, 106) and the first (42, 48; 96, 98) or another second ferromagnetic layer is systematically an antiferromagnetic RKKY coupling.

6. Magnet according to any one of the preceding claims, in which the stack comprises:
- an end antiferromagnetic layer (36), this end antiferromagnetic layer being the closest to a top of the stack, and
- immediately below this end antiferromagnetic layer, a pattern (34; 82; 132) repeated n times, immediately successively, in a stacking direction of the ferromagnetic and antiferromagnetic layers, where n is an integer greater than or equal to one, this pattern comprising in the order moving in the stacking direction:
- a first antiferromagnetic layer (40),
- a first ferromagnetic layer (42) the magnetization direction of which is pinned by exchange coupling with the first antiferromagnetic layer,
- a superimposition of p second ferromagnetic layers (46; 46, 134), the magnetization direction of the second ferromagnetic layer (46), located at the bottom of this superimposition, being pinned by RKKY coupling with the first ferromagnetic layer (42) located below, and the magnetization direction of each other second ferromagnetic layer (134) of this superimposition being pinned by RKKY coupling with the second ferromagnetic layer (46) of this superimposition located just below, where p is a whole number greater than or equal to one, and
- a first ferromagnetic layer (50) the magnetization direction of which is pinned by exchange coupling with the first antiferromagnetic layer (40) of the following pattern in the stack or with the end antiferromagnetic layer (36).

7. Magnet according to Claim 6, in which p is between one and ten, and preferably between one and two.

8. Magnet according to any one of Claims 1 to 5, in which the stack comprises a pattern (92) repeated n times, immediately successively, in a stacking direction of the antiferromagnetic and ferromagnetic layers, where n is an integer greater than or equal to one, this pattern comprising:
- an antiferromagnetic layer (94),
- on each side of this antiferromagnetic layer:
• a first ferromagnetic layer (96, 98) the magnetization direction of which is pinned by exchange coupling with this antiferromagnetic layer, and
• a second ferromagnetic layer (104, 106) the magnetization direction of which is pinned by RKKY coupling with this first ferromagnetic layer, and
- a lamination layer (108) made of a non-magnetic material located at one end of this pattern for magnetically isolating this pattern from the immediately following or preceding pattern in this same stack.

9. Magnet according to either of Claims 6 or 8, in which n is greater than or equal to two or five.

10. Magnet according to any one of the preceding claims, in which the magnet exhibits a form factor greater than or equal to two, the form factor being defined as the ratio of the length over the width of the parallelepiped of smallest volume fully containing the stack and the magnetization direction of each ferromagnetic layer of the permanent magnet being pinned in a direction parallel to the length of this parallelepiped.

11. Magnet according to any one of the preceding claims, in which, for all the pairs of ferromagnetic layers of the stack, one of the selected relationships in the group consisting of the relationships Mᵢt₁ ≥ 5*M₂t₂ and M₂t₂ ≥ 5* M₁t₁, is satisfied, where:
- M₁ and t₁ are, respectively, the magnetization and the thickness of the first ferromagnetic layer of the pair, and
- M2 and t2 are, respectively, the magnetization and the thickness of the second ferromagnetic layer of the same pair,
each pair of ferromagnetic layers of the stack comprising a second ferromagnetic layer and the first ferromagnetic layer which pins, only by RKKY coupling, the magnetization direction of this second ferromagnetic layer.

12. Magnetic field sensor comprising:
- a substrate (12) extending essentially in a plane termed the "plan of the substrate,"
- at least one permanent magnet (20-22; 80; 90; 130) movable with respect to the substrate in response to a variation in the amplitude or direction of a magnetic field to be measured,
- a transducer (24-26) attached onto the substrate, capable of converting a movement of the permanent magnet into an electrical value representative of the amplitude or direction of the magnetic field to be measured,
**characterized in that** the permanent magnet is compliant with any one of Claims 1 to 11.

13. Method for manufacturing a permanent magnet compliant with any one of Claims 1 to 11, this method comprising:
a) the formation (70) of a stack of first ferromagnetic and antiferromagnetic layers,
b) heating (74) the stack so as to reach a temperature higher than an ordering temperature for the material of the magnetic layers of the stack,
c) when the temperature is higher than the ordering temperature, applying (76) a first magnetic field for aligning the magnetization direction of the ferromagnetic layers along a predetermined desired direction,
d) cooling (78) the stack in the presence of a second magnetic field less than the first magnetic field to make an exchange coupling appear between each first ferromagnetic layer and an antiferromagnetic layer of the same stack,
and step a) comprises the formation, in the stack, of second ferromagnetic layers separated from the first ferromagnetic layers and other second ferromagnetic layers by non-magnetic layers the thickness of which is capable of enabling the appearance of an RKKY coupling between this second ferromagnetic layer and this first ferromagnetic layer or this other second ferromagnetic layer so as to pin the magnetic direction of this second ferromagnetic layer only by an RKKY coupling with one of the first ferromagnetic layers or with at least one of the other second ferromagnetic layers.
